# EUROPEAN PATENT APPLICATION

(11) **EP 4 745 586 A1**
(43) Date of publication of application: **20.05.2026**
(21) Application number: 25210964.0
(22) Date of filing: 24.10.2025
(51) Int. Cl.: G01R 15/20, G01R 19/165

(54) **INTELLIGENT BATTERY CURRENT MONITOR**

(30) Priority: 15.11.2024 US 202463721066 P
(71) Applicant: Vertiv Corporation, Westerville, OH 43082 (US)
(72) Inventor: YAHYA, Sam, Westerville, 43082 (US); UPPHED, Melinda, Westerville, 43082 (US)
(74) Representative: Bryn-Jacobsen, Caelia

(57) **Abstract**

A direct current (DC) power supply system and methodology for monitoring current in the system. In examples, the system includes a battery power source, a condcutor coupled to the battery power source, and a battery monitor for monitoring operating current. In examples, the battery monitor includes a substrate, a first hall-effect sensor mounted on the substrate and configured to detect a first range of electrical current, a second hall-effect sensor mounted on the substrate and configured to detect a second range of electrical current, and a controller coupled to the sensors and configured to receive voltage output signals from the sensors and determine operating electrical current flowing through the battery cable. In examples, the sensors are associated with different operating states of the system.

## Description

### CROSS REFERENCE TO RELATED APPLICATION

This application claims the benefit of priority of U.S. Application Number 63/721,066 filed November 15, 2024.

### TECHNICAL FIELD AND BACKGROUND

The present disclosure is directed generally to monitoring operating current in power supply systems, and more particularly, to an intelligent battery current monitor including two or more hall-effect sensors.

Traditional direct current (DC) power supply systems used in data centers and other applications monitor operating current using a battery shunt including series resistive elements. In high current applications, series resistive elements generate extreme heat that can be damaging to sensitive electronics. In addition to heat generation, series resistive elements have a fixed narrow sensing range that makes them incapable of monitoring broad ranges of operating currents. For example, measurement deviations are unacceptably high when using a high current battery shunt to measure low DC current (e.g., close to 0A).

As the demand for power increases in DC power supply systems, while at the same time managing packaging constraints, there is a need for a current monitoring solution that is isolated from high voltages and capable of monitoring broad ranges of operating currents.

### SUMMARY

According to one aspect, the present disclosure is directed to a direct current (DC) power supply system including a battery power source, a conductor coupled to the battery power source, and a battery monitor for monitoring operating current. In examples, the battery monitor includes a substrate, a first hall-effect sensor mounted on the substrate and configured to detect a first range of electrical current flowing through the conductor, a second hall-effect sensor mounted on the substrate and configured to detect a second range of electrical current flowing through the conductor, and a controller coupled to the first and second hall-effect sensors, the controller configured to receive voltage output signals from the first and second hall-effect sensors and determine, from the voltage output signals received, operating electrical current flowing through the conductor.

In some examples, the first hall-effect sensor has a first sensing range corresponding to a first predetermined current operating state of the DC power supply system, and the second hall-effect sensor has a second sensing range corresponding to a second predetermined current operating state of the DC power supply system, wherein current associated with the second sensing range is higher than current associated with the first sensing range.

In some examples, the controller is further configured to disconnect the battery power source from a DC load coupled to the battery power source.

In some examples, the conductor is a battery cable or a busbar.

In some examples, the first and second sensing ranges at least partially overlap.

In some examples, the substrate is the conductor and the conductor is a busbar.

In some examples, the substrate is implemented as a battery link and the first and second hall-effect sensors are mounted mechanically in series.

In some examples, the controller is further configured to, based on the operating electrical current determined to be flowing through the conductor, control electrical current flowing into or out of the battery power source.

In some examples, the battery power source comprises at least one Lithium-ion battery.

According to another aspect, the present disclosure is directed to a battery monitor for monitoring operating current in a direct current (DC) power supply system. In examples, the battery monitor includes a conductor, a first hall-effect sensor mounted on the conductor and configured to detect a first range of electrical current flowing through the conductor coupled to a battery power source, a second hall-effect sensor mounted on the conductor and configured to detect a second range of electrical current flowing through the conductor, and a controller coupled to the first and second hall-effect sensors, the controller configured to receive voltage output signals from the first and second hall-effect sensors and determine, from the voltage output signals received, operating electrical current flowing through the conductor.

In some examples, the first hall-effect sensor has a first sensing range corresponding to a first predetermined current operating state of the DC power supply system, the second hall-effect sensor has a second sensing range corresponding to a second predetermined current operating state of the DC power supply system, electrical current associated with the second sensing range is higher than electrical current associated with the first sensing range, and the first and second sensing ranges at least partially overlap.

In some examples, the controller is further configured to disconnect the battery power source from a DC load coupled to the battery power source.

In some examples, the conductor in a busbar and the first and second hall-effect sensors are mounted mechanically in series on the busbar.

In some examples, the controller is further configured to, based on the operating electrical current determined to be flowing through the conductor, control electrical current flowing into or out of the battery power source.

According to a further aspect, the present disclosure is directed to a method for monitoring operating current in a direct current (DC) power supply system. In examples, the method includes providing a battery monitor including a conductor, a first hall-effect sensor coupled to the conductor, a second hall-effect sensor coupled to the conductor, and a controller coupled to the first and second hall-effect sensors. The method further includes detecting, by the first hall-effect sensor, a first range of electrical current flowing through the conductor from a coupled battery power source, detecting, by the second hall-effect sensor, a second range of electrical current flowing through the conductor from the coupled battery source, receiving, by the controller, voltage output signals from the first and second hall-effect sensors, and determining, by the controller, and based on the voltage output signals received from the first and second hall-effect sensors, operating electrical current flowing through the conductor.

In some examples, the first hall-effect sensor has a first sensing range corresponding to a first predetermined current operating state of the DC power supply system, and the second hall-effect sensor has a second sensing range corresponding to a second predetermined current operating state of the DC power supply system, wherein current associated with the second sensing range is higher than current associated with the first sensing range.

In some examples, the controller is configured to display, via a display coupled to the controller, the output electrical current determined by the controller.

In some examples, the first and second sensing ranges at least partially overlap.

In some examples, the method further includes disconnecting, by the controller, the battery power source from a DC load coupled to the battery power source.

In some examples, the method further includes controlling, by the controller, and based on the operating electrical current determined to be flowing through the battery cable, electrical current flowing into or out of the battery power source.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated and some features may be omitted or may be represented schematically in the interest of clarity. Like reference numerals in the drawings may represent and refer to the same or similar element, feature, or function. In the drawings:
FIG. 1 is a schematic diagram of a DC power supply system, in accordance with an example of the present disclosure;
FIG. 2 is a graph illustrating a measurement scheme of the intelligent battery monitor, in accordance with an example of the present disclosure; and
FIG. 3 is a flow diagram of a method for monitoring operating current in a DC power supply system, in accordance with an example of the present disclosure.

### DETAILED DESCRIPTION

Before explaining one or more examples of the disclosure in detail, it is to be understood that the examples are not limited in their application to the details of construction and the arrangement of the components or steps or methodologies set forth in the following description or illustrated in the drawings. In the following detailed description of examples, numerous specific details may be set forth in order to provide a more thorough understanding of the disclosure. However, it will be apparent to one of ordinary skill in the art having the benefit of the instant disclosure that the examples disclosed herein may be practiced without some of these specific details. In other instances, well-known features may not be described in detail to avoid unnecessarily complicating the instant disclosure.

As used herein a letter following a reference numeral is intended to reference an example of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present) and B is false (or not present), A is false (or not present) and B is true (or present), and both A and B are true (or present).

In addition, use of "a" or "an" may be employed to describe elements and components of examples disclosed herein. This is done merely for convenience and "a" and "an" are intended to include "one" or "at least one," and the singular also includes the plural unless it is obvious that it is meant otherwise.

Finally, as used herein any reference to "one example" or "some examples" means that a particular element, feature, structure, or characteristic described in connection with the example is included in at least one example disclosed herein. The appearances of the phrase "in some examples" in various places in the specification are not necessarily all referring to the same example, and examples may include one or more of the features expressly described or inherently present herein, or any combination or sub-combination of two or more such features, along with any other features which may not necessarily be expressly described or inherently present in the instant disclosure.

Broadly, the present disclosure is directed to a DC power supply system and methodology for monitoring operating current in a DC power supply system. In examples, the system includes a battery monitor including two or more hall-effect sensors for detecting electrical current flowing through a conductor, for instance a busbar or battery cable, coupled to a power source, for instance at least one battery. In examples, each hall-effect sensor operates over a predefined sensing range corresponding to an operating state of the system, for instance a first hall-effect sensor may have a first sensing range corresponding to a first (e.g., lower) current operating state of the system, and a second hall-effect sensor may have a second sensing range corresponding to a second (e.g., higher) current operating state of the system. With this configuration, the battery monitor is capable of accurately monitoring various operating states of a power supply system currents without having to mitigate heat generation and power loss associated with resistive elements, and more accurate current values can be obtained at low current and high current measurements.

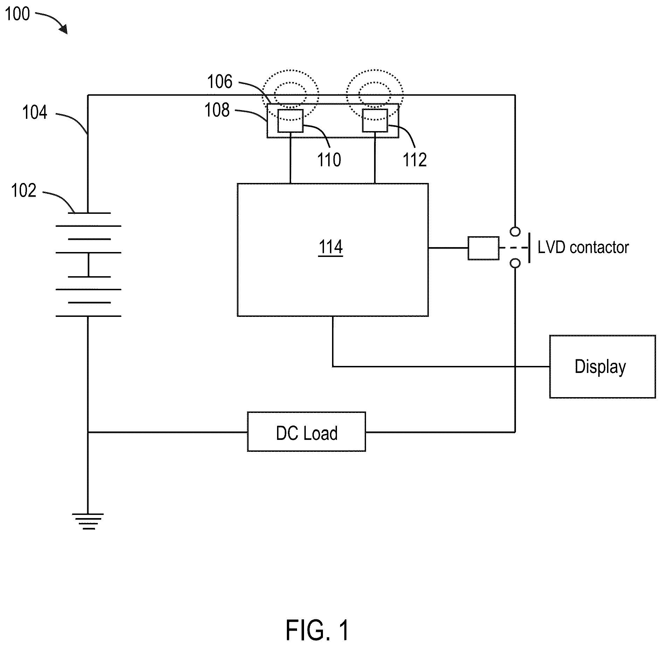

FIG. 1 illustrates an example of a DC power supply system 100 according to the present disclosure. For example, the DC power supply system 100 may be implemented as a DC backup power supply system for use in data center or telecom applications. The system 100 generally includes a power source such as a battery power source 102 including at least one battery. For example, the battery power source 102 may include a plurality of batteries (e.g., strings) forming a battery stack. Battery chemistries may include, but are not limited to, Lithium-ion (Li-ion), Nickel Metal Hydride (NiMH), and Nickel Cadmium (NiCad). Certain battery chemistries may be preferred over others depending on application, capacity requirements, environment, cost, etc.

The DC power supply system 100 includes a charge-discharge circuit for charging and discharging power between the battery power source 102 and a coupled DC electrical transmission line(s), referred to herein simply as a conductor 104. In examples, the conductor 104 may be a busbar, a battery cable, or another type of conductive element. A battery monitor 106 according to the present disclosure is coupled to, positioned along, or positioned in sensing proximity to the conductor 104, in other words on the current flow path. For example, the battery monitor 106 may be implemented as a battery link coupled between the conductor 104 and a further electrical transmission line. In use, the battery monitor 106 is configured to detect an amount of operating current flowing into and out of the battery power source 102 such that, for example, an operating state of the DC power supply system 100 and a charged state of the battery power source 102 can be monitored.

In examples, the battery monitor 106 generally includes a substrate 108, a first hall-effect sensor 110 mounted on or coupled to the substrate 108, and a second hall-effect sensor 112 mounted on or coupled to the substrate 108. In a particular conceived example, the first and second hall-effect sensors 110, 112 may be mounted in series mechanically on the same centerline. In examples, the battery monitor 106 may include additional hall-effect sensors (e.g., third sensor, fourth sensor...nth senor) mounted on the substrate 108 depending on the operating capabilities of the system. For purposes of this disclosure, first and second hall-effect sensors 110, 112 are discussed to illustrate the ability to detect different amounts of electrical current.

The first and second hall-effect sensors 110, 112 are positioned in sensing proximity to the conductor 104 such that the magnetic field generated by the electrical current flowing through the conductor 104 can be detected to generate, as known in the art of hall-effect sensors, a voltage signal proportional to the magnitude of the magnetic field. In examples, the substrate 108 may be coupled to or positioned alongside or over the conductor 104 such that the first and second hall-effect sensors 110, 112 are positioned relative to the conductor 104 to detect the generated magnetic field without requiring physical contact with the conductor 104. In examples, the substrate 108 may be a control/interface board such as a (PCB) on the battery busbar.

In examples, the first hall-effect sensor 110 may operate over a first current sensing range corresponding to low current associated with charging (e.g., charging current) or discharging current, and the second hall-effect sensor 112 may operate over a second current sensing range corresponding to higher current associated with discharging (e.g., discharging current) or charging current. Considering the potential disparity between the charging and discharging currents, particularly in high voltage systems (e.g., >400V DC systems), the first hall-effect sensor 110 can be used to detect the charging current with high accuracy for a specific area, and the second hall-effect sensor 112 can be used to detect a second part of the current when the current is increasing (or decreasing) with high accuracy. In the case of a DC power supply system including Li-ion batteries, accurate measurement of the battery charging current is critical to ensure battery health and lifespan.

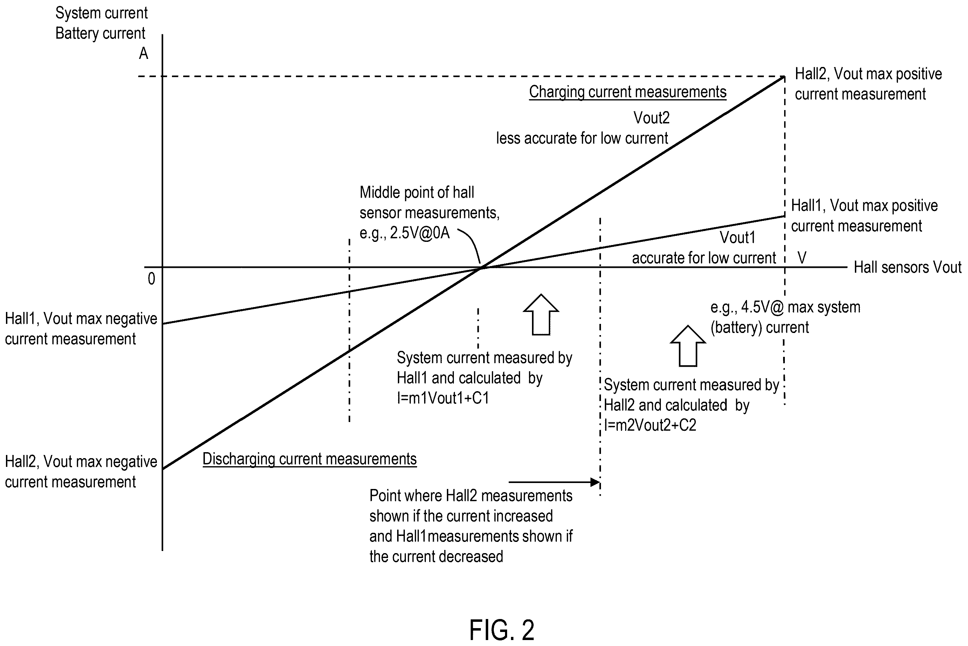

FIG. 2 is a graph illustrating an example of a measurement scheme for the battery monitor according to the present disclosure. For example, first and second hall-effect sensors (Hall1 and Hall2) are selected having different current sensing ranges, wherein the current sensing range of Hall1 corresponds to a 'lower' current sensing range and the current sensing range of Hall2 corresponds to a 'higher' current sensing range. Current may be monitored in that current associated with a 'lower' voltage (i.e., nearer the middle point of Hall1 and Hall2) may be measured with Hall1 optimized for that current range whereas current associated with a 'higher' voltage (i.e., farther away from the middle point of Hall1 and Hall2) may be measured by Hall2 optimized for the higher current range. Charging and discharging current may be measured the same way in that the appropriate hall sensor is selected to measure the current based on the operating current of the system to obtain the most accurate current measurement.

In further examples, the current sensing ranges of the first and second hall-effect sensors 110, 112 may be overlapping as shown in FIG. 2, or non-overlapping in case of a voltage system configured to operate at disparate voltages (e.g., both very low and very high voltages). For example, in a voltage system capable of operating at disparate voltages, the first hall-effect sensor 110 detection may be programmed to charging current detection whereas the second hall-effect sensor 112 detection may be programmed to discharging current detection. In this configuration, the first hall-effect sensor 110 may be configured to detect charging current with accuracy and discharging current with low accuracy, whereas the second hall effect sensor 112 may be configured to detect discharging current with high accuracy and charging current with low accuracy. At least partially overlapping current sensing ranges may be employed with low voltage systems and/or where redundancy of a particular operating current range is desired. In examples, the operating ranges of the first and second hall-effect sensors 110, 112 may be independently programmable depending on the capabilities of the system, and within the confines of the capabilities of the hall-effect sensors 110, 112.

Referring again to FIG. 1, the battery monitor 106 further includes a controller 114 mounted to the substrate 106 or located remotely, for instance as part of a further system controller. Each of the first and second hall-effect sensors 110, 112 are communicatively coupled to the controller 114 such that voltage signals output by the first and second hall-effect sensors 110, 112 are received by the controller 114. In examples, the controller 114 includes an analog-to-digital converter for converting the analog signals received to digital signals to be analyzed to determine the operating current of the system and for further processing. In examples, a conversion from a sensing voltage to the measured current may be performed according to a straight line equation that has been calculated according to the calibration or 'configuration' of the hall sensor, e.g., I_{battery}=mVₒᵤₜ+C, where I is the battery current, m and C are constants, and Vₒᵤₜ is the output voltage received from the hall sensor.

In examples, the controller 114 may be configured to control charging and discharging based on the determined operating current to protect the battery power source 102 from under-voltage and over-voltage conditions. For example, in the event of an over-voltage condition determined by the controller 114 from the output signal received from the first hall-effect sensor 110, the controller 114 may be configured to stop or change the flow of current into the battery power source 102, for instance by controlling charging-related components (e.g., electrical switch or other electrical current controller) or by outputting instructions to a further controller configured to control charging. In the event of an over-voltage condition determined by the controller 114 from the output signal received from the second hall-effect sensor 112, the controller 114 may be configured to stop or change the flow of current out of the battery power source 102 by controlling discharging-related components (e.g., electrical switch or other electrical current controller) or by outputting instructions to a further controller configured to control discharging. Thus, in examples, the controller 114 may protect the battery power source 102 and overall system 100 by controlling the flow or current responsive to the state of the operating current.

In examples, the controller 114 may be configured to program the electrical current sensing ranges of the first and second hall-effect sensors 110, 112. For example, the sensing range of the first hall-effect sensor 110 may be programmed to detect a low operating current corresponding to charging, the second hall-effect sensors 112 may be programmed to detect a high operating current corresponding to charging (e.g., both sensors working on the same task, charging or discharging but one for low current and the other for higher current, wherein the changeover point is predetermined), and the controller 114 may be configured to utilize the appropriate output voltage signal(s) depending on the operating state of the system. In examples, the first and second hall-effect sensors 110, 112 are be connected in series mechanically and therefore operate continuously to detect current and output voltage signals, and the controller 114 may be configured to receive the output signals from both hall-effect sensors simultaneously, analyze the signals, and communicate the signals separately for display via an interface of the controller 114 or separate control unit.

In examples, the first and second hall-effect sensors 110, 112 are utilized to detect both charging and discharging currents for DC systems wherein one hall-effect sensor is programmed to detect lower current and the other programmed to detect higher current, and wherein the controller 114 is configured to output the operating current based on the operating state of the system.

In examples, the controller 114 may include hardware to convert the received output signals from analog to digital. The controller 114 may further include one or more processors and a memory device, or memory. For example, the one or more processors may be configured to execute a set of program instructions maintained in the memory device. The one or more processors may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more processors may include any device configured to execute algorithms and/or instructions (e.g., program instructions stored in memory). Moreover, different subsystems of the present disclosure may include a processor or logic elements suitable for carrying out at least a portion of the steps described herein. Further, the steps described herein may be carried out by a single controller or, alternatively, multiple controllers. Further, the controller may analyze or otherwise process data received from the sensors and feed the data to additional components or external to the system.

The memory device may include any storage medium known in the art suitable for storing program instructions executable by the associated one or more processors. For example, the memory device may include a non-transitory memory medium. As an additional example, the memory device may include, but is not limited to, a read-only memory, a random-access memory, a magnetic or optical memory device (e.g., disk), a magnetic tape, a solid-state drive and the like. It is further noted that the memory device may be housed in a common controller housing with the one or more processors.

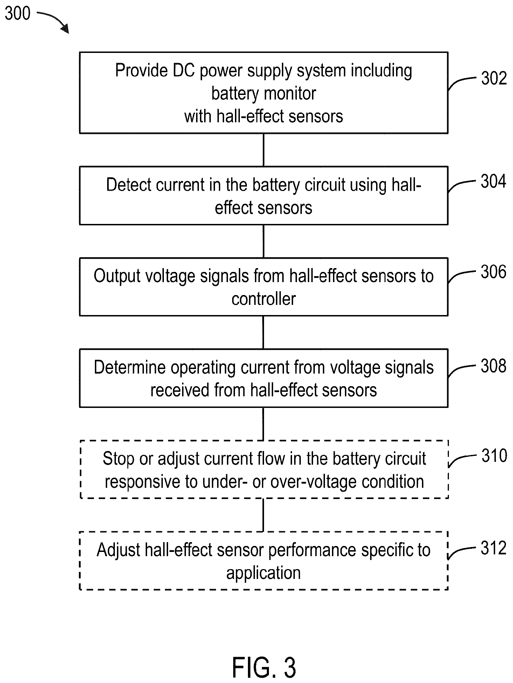

FIG. 3 illustrates an example of a flow diagram of a current sensing methodology 300 according to the present disclosure. In Step 302, the method begins with providing a DC power supply system 100 including the battery power source 102, the charging/discharging circuitry, and the battery monitor 106 as described above. In Step 304, operating current in the circuitry is detected by the first and second hall-effect sensors 110, 112, but with different accuracy depending on the predefined sensing ranges. In Step 306, sensor signals from at least one of the first and second hall-effect sensors 110, 112 are output to the controller 114 based on the detected current. In Step 308, the controller 114 determines the operating current from the output signals received from the hall-effect sensors 110, 112 according to a predetermined algorithm to inform about the operating current.

The current measurement may be presented to confirm correct system performance. In an optional Step 310, in the event of an under-voltage or over-voltage condition, the controller 114 may operate, directly or indirectly, to stop or modify the flow of current. In a further optional Step 312, the controller 114 may be used to independently adjust the sensing ranges of the first and second hall-effect sensors 110, 112. In use, the battery monitor 106 can be used to provide accurate operating current measurement over a wide range of operating currents by utilizing one or more hall-effect sensors each optimized to detect current in a predefined range, and with the ability to adjust sensitivity based on the power capabilities of the system.
Further examples are set out in the clauses below:
1. A direct current (DC) power supply system, comprising:
   a battery power source;
   a conductor coupled to the battery power source; and
   a battery monitor configured to monitor operating current, the battery monitor comprising:
      a substrate;
      a first hall-effect sensor mounted on the substrate and configured to detect a first range of electrical current flowing through the conductor;
      a second hall-effect sensor mounted on the substrate and configured to detect a second range of electrical current flowing through the conductor; and
      a controller coupled to the first and second hall-effect sensors, the controller configured to receive voltage output signals from the first and second hall-effect sensors and determine, from the voltage output signals received, operating electrical current flowing through the conductor.
2. The DC power supply system according to clause 1, wherein:
   the first hall-effect sensor has a first sensing range corresponding to a first predetermined current operating state of the DC power supply system; and
   the second hall-effect sensor has a second sensing range corresponding to a second predetermined current operating state of the DC power supply system,
   wherein current associated with the second sensing range is higher than current associated with the first sensing range.
3. The DC power supply system according to clause 2, wherein the controller is further configured to disconnect the battery power source from a DC load coupled to the battery power source.
4. The DC power supply system according to clause 2 or 3, wherein the conductor is a battery cable or a busbar.
5. The DC power supply system according to any one of clauses 2-4, wherein the first and second sensing ranges at least partially overlap.
6. The DC power supply system according to any one of the preceding clauses, wherein the substrate is the conductor and the conductor is a busbar.
7. The DC power supply system according to any one of the preceding clauses, wherein the substrate is implemented as a battery link and the first and second hall-effect sensors are mounted mechanically in series.
8. The DC power supply system according to any one of the preceding clauses, wherein the controller is further configured to, based on the operating electrical current determined to be flowing through the conductor, control electrical current flowing into or out of the battery power source.
9. The DC power supply system according to any one of the preceding clauses, wherein the battery power source comprises at least one Lithium-ion battery.
10. A battery monitor for monitoring operating current in a direct current (DC) power supply system, the battery monitor comprising:
   a conductor;
   a first hall-effect sensor mounted on the conductor and configured to detect a first range of electrical current flowing through the conductor coupled to a battery power source;
   a second hall-effect sensor mounted on the conductor and configured to detect a second range of electrical current flowing through the conductor; and
   a controller coupled to the first and second hall-effect sensors, the controller configured to receive voltage output signals from the first and second hall-effect sensors and determine, from the voltage output signals received, operating electrical current flowing through the conductor.
11. The battery monitor according to clause 10, wherein:
   the first hall-effect sensor has a first sensing range corresponding to a first predetermined current operating state of the DC power supply system;
   the second hall-effect sensor has a second sensing range corresponding to a second predetermined current operating state of the DC power supply system;
   electrical current associated with the second sensing range is higher than electrical current associated with the first sensing range; and
   the first and second sensing ranges at least partially overlap.
12. The battery monitor according to clause 10 or 11, wherein the controller is further configured to disconnect the battery power source from a DC load coupled to the battery power source.
13. The battery monitor according to any one of clauses 10-12, wherein the conductor in a busbar and the first and second hall-effect sensors are mounted mechanically in series on the busbar.
14. The battery monitor according to any one of clauses 10-13, wherein the controller is further configured to, based on the operating electrical current determined to be flowing through the conductor, control electrical current flowing into or out of the battery power source.
15. A method for monitoring operating current in a direct current (DC) power supply system, the method comprising the steps of:
   providing a battery monitor comprising:
   a conductor;
      a first hall-effect sensor mounted on the conductor;
   a second hall-effect sensor mounted on the conductor; and
   a controller coupled to the first and second hall-effect sensors;
   detecting, by the first hall-effect sensor, a first range of electrical current flowing through the conductor from a coupled battery power source;
   detecting, by the second hall-effect sensor, a second range of electrical current flowing through the conductor from the coupled battery source;
   receiving, by the controller, voltage output signals from the first and second hall-effect sensors; and
   determining, by the controller, and based on the voltage output signals received from the first and second hall-effect sensors, operating electrical current flowing through the conductor.
16. The method according to clause 15, wherein:
   the first hall-effect sensor has a first sensing range corresponding to a first predetermined current operating state of the DC power supply system; and
   the second hall-effect sensor has a second sensing range corresponding to a second predetermined current operating state of the DC power supply system,
      wherein current associated with the second sensing range is higher than current associated with the first sensing range.
17. The method according to clause 16, wherein the controller is configured to display, via a display coupled to the controller, the output electrical current determined by the controller.
18. The method according to clause 16 or 17, wherein the first and second sensing ranges at least partially overlap.
19. The method according to any one of clauses 16-18, further comprising the step of disconnecting the battery power source from a DC load coupled to the battery power source.
20. The method according to any one of clauses 15-19, the method further comprising the step of controlling, by the controller, and based on the operating electrical current determined to be flowing through the battery cable, electrical current flowing into or out of the battery power source.

From the above description, it is clear that the present disclosure is well adapted to achieve the objectives and to attain the advantages mentioned herein as well as those inherent in the present disclosure disclosed herein. While examples of the present disclosure disclosed herein has been described for purposes of this disclosure, it will be understood that numerous changes may be made which will readily suggest themselves to those skilled in the art and which are accomplished within the broad scope and coverage of the present disclosure disclosed and claimed herein.

## Claims

1. A battery monitor for monitoring operating current in a direct current (DC) power supply system, the battery monitor comprising:
a conductor;
a first hall-effect sensor mounted on the conductor and configured to detect a first range of electrical current flowing through the conductor coupled to a battery power source;
a second hall-effect sensor mounted on the conductor and configured to detect a second range of electrical current flowing through the conductor; and
a controller coupled to the first and second hall-effect sensors, the controller configured to receive voltage output signals from the first and second hall-effect sensors and determine, from the voltage output signals received, operating electrical current flowing through the conductor.

2. The battery monitor according to claim 1, wherein:
the first hall-effect sensor has a first sensing range corresponding to a first predetermined current operating state of the DC power supply system;
the second hall-effect sensor has a second sensing range corresponding to a second predetermined current operating state of the DC power supply system;
electrical current associated with the second sensing range is higher than electrical current associated with the first sensing range; and
the first and second sensing ranges at least partially overlap.

3. The battery monitor according to claim 1 or 2, wherein the controller is further configured to disconnect the battery power source from a DC load coupled to the battery power source.

4. The battery monitor according to any one of the preceding claims, wherein the conductor in a busbar and the first and second hall-effect sensors are mounted mechanically in series on the busbar.

5. The battery monitor according to any one of the preceding claims, wherein the controller is further configured to, based on the operating electrical current determined to be flowing through the conductor, control electrical current flowing into or out of the battery power source.

6. A direct current (DC) power supply system, comprising the battery monitor of claim 1, and further comprising:
a battery power source;
wherein the conductor is coupled to the battery power source; and
the battery further comprises monitor configured to monitor operating current, the battery monitor comprising:
a substrate.

7. The DC power supply system according to claim 6, wherein:
the first hall-effect sensor has a first sensing range corresponding to a first predetermined current operating state of the DC power supply system; and
the second hall-effect sensor has a second sensing range corresponding to a second predetermined current operating state of the DC power supply system,
wherein current associated with the second sensing range is higher than current associated with the first sensing range.

8. The DC power supply system according to claim 7, wherein the controller is further configured to disconnect the battery power source from a DC load coupled to the battery power source.

9. The DC power supply system according to claim 7 or 8, wherein the conductor is a battery cable or a busbar.

10. The DC power supply system according to any one of claims 7-9, wherein the first and second sensing ranges at least partially overlap.

11. The DC power supply system according to any one of claims 6-10, wherein the substrate is the conductor and the conductor is a busbar.

12. The DC power supply system according to any one of claims 6-11, wherein the substrate is implemented as a battery link and the first and second hall-effect sensors are mounted mechanically in series.
claims 6-, wherein the controller is further configured to, based on the operating electrical current determined to be flowing through the conductor, control electrical current flowing into or out of the battery power source; or optionally
wherein the battery power source comprises at least one Lithium-ion battery.

13. A method for monitoring operating current in a direct current (DC) power supply system, the method comprising the steps of:
providing a battery monitor comprising:
a conductor;
a first hall-effect sensor mounted on the conductor;
a second hall-effect sensor mounted on the conductor; and
a controller coupled to the first and second hall-effect sensors;
detecting, by the first hall-effect sensor, a first range of electrical current flowing through the conductor from a coupled battery power source;
detecting, by the second hall-effect sensor, a second range of electrical current flowing through the conductor from the coupled battery source;
receiving, by the controller, voltage output signals from the first and second hall-effect sensors; and
determining, by the controller, and based on the voltage output signals received from the first and second hall-effect sensors, operating electrical current flowing through the conductor.

14. The method according to claim 13, wherein:
the first hall-effect sensor has a first sensing range corresponding to a first predetermined current operating state of the DC power supply system; and
the second hall-effect sensor has a second sensing range corresponding to a second predetermined current operating state of the DC power supply system,
wherein current associated with the second sensing range is higher than current associated with the first sensing range; or optionally
further comprising the step of controlling, by the controller, and based on the operating electrical current determined to be flowing through the battery cable, electrical current flowing into or out of the battery power source.

15. The method according to claim 13, wherein the controller is configured to display, via a display coupled to the controller, the output electrical current determined by the controller; or optionally
wherein the first and second sensing ranges at least partially overlap; or optionally
further comprising the step of disconnecting the battery power source from a DC load coupled to the battery power source.
